# EUROPEAN PATENT APPLICATION

(11) **EP 3 327 094 A1**
(43) Date of publication of application: **30.05.2018**
(21) Application number: 17202400.2
(22) Date of filing: 17.11.2017
(51) Int. Cl.: C09D 11/03, C04B 35/571, C09D 11/101, C09D 11/102, C09D 183/16, C08L 83/16

(54) **HIGH TEMPERATURE INKS FOR ELECTRONIC AND AEROSPACE APPLICATIONS**

(30) Priority: 29.11.2016 US 201615364172
(71) Applicant: United Technologies Corporation, Farmington, CT 06032 (US)
(72) Inventor: SCHMIDT, Wayde R, Ponfret Center, CT Connecticut 06259 (US); SHEEDY, Paul, Bolton, CT Connecticut 06043 (US)
(74) Representative: Towler, Philip Dean

(57) **Abstract**

A printable material in ink form for forming electronic and structural components capable of high temperature performance includes a polymeric or oligomeric ceramic precursor, a filler material and an optional liquid carrier. The ceramic precursor materials may be silicon carbide, silicon oxycarbide, silicon nitride, silicon carbonitride, silicon oxycarbonitride, gallium containing group 13 oligomeric compounds and mixtures thereof. The ceramic precursor may be deposited by a direct ink writing (DIW) process.

## Description

### BACKGROUND

An increasing number of industries are requiring electronics that can operate reliably in harsh environments including high temperatures. The oldest, and currently largest, user of high temperature electronics is the downhole oil and gas industry where operating temperatures are a function of the underground depth of a well. In this industry, electronics and sensors steer the drilling equipment and monitor its health. The aviation industry now has a growing movement toward "more electric aircraft" (MEA). Part of this effort includes replacing traditional centralized engine controllers with distributed control systems. Moving to a distributed control scheme places the engine controls closer to the high temperature environment of the engine, which can save weight and increase the reliability of the control system. Another aspect of MEA replaces hydraulic systems with power electronics and electronic controls, which improve reliability and reduce maintenance costs. Similar initiatives are occurring in the automotive industry.

State-of-the-art electronic materials for high temperature applications are shifting to SiC, GaAs, and GaN, for example. Microelectronic components containing these materials are conventionally assembled using costly vapor deposition procedures requiring, for instance, multistep deposition with masking. It is beneficial to assemble high temperature electronic components by methods involving direct bulk material transfer rather than vapor phase material transfer for schedule, financial, and quality reasons. However, it has been a challenge to develop material that is easily formable into high temperature components.

### SUMMARY

A printable material in ink form for forming electronic and structural components of ceramic materials is disclosed. The printable ink is capable of high temperature performance. The printable ink includes a polymeric or oligomeric ceramic precursor. It also includes a filler material, which may comprise an active and/or passive filler material, and an optional liquid carrier.

In an embodiment a method of forming electronic and structural components capable of high temperature performance may include preparing a dispersion or solution for application as an ink in a direct ink writing (DIW) process comprised of a polymeric or oligomeric ceramic precursor. The method may further include adding a filler material, an optional liquid carrier to the ink and adjusting the rheology of the ink to that required for direct ink writing. The method may further include transferring the ink to a direct ink writing (DIW) system and forming a component by the DIW system. Heating the component to decompose the polymeric precursor and pyrolyze the component followed by heating to a temperature may transform the material of the component to a more crystalline ceramic to complete the method.

### BRIEF DESCRIPTION OF THE DRAWINGS

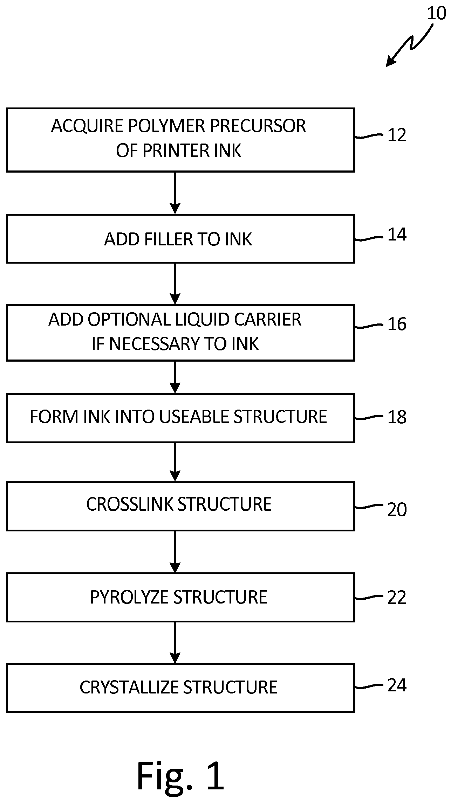

FIG. 1 is a flow diagram illustrating a method of forming a high temperature component with high temperature ink according to an embodiment of the present invention.

### DETAILED DESCRIPTION

An exemplary direct bulk material transfer method for forming high temperature electronic components and other high temperature resistant structures may be a direct ink write (DIW) method. DIW methods include ink jet, extrusion, aerosol jet, plasma/thermal spray, electro spray, micro cold spray, 3D printing, fused deposition, micro pen writing, and other processes known in the art. There can be a number of benefits of direct ink writing methods, including conservation of material, near net shape forming, conformal printing on complex curved structures and ease in forming complicated 3D structures, for example.

Disclosed herein is a family of inks that may be delivered via a direct write method that may be capable of high temperature performance. These inks may be applicable for forming devices containing high temperature semiconductors such as silicon carbide, gallium arsenide, and/or gallium nitride for electronic applications as mentioned above. These inks may also be applicable for non-electronic application where the high temperature material (silicon carbide, for example) may be put into service as a caulk, glue, adhesive, paste, putty, or other applications that may be delivered via a direct write method.

The family of inks disclosed herein may contain preceramic polymeric precursors as well as reactive and/or inert fillers that may allow the inks to be easily deposited and converted into high temperature material such as silicon carbide, for example. Precursor ceramic polymer materials for silicon carbide may include polycarbosilane, polysilazane, polycarbosilazane, polysilane, polycarbosiloxane and metal-modified preceramic polymers. Aluminum and boron are typical dopants for semiconducting silicon carbide. In an embodiment that includes these dopants, precursor ceramic polymer materials may include boropolycarbosiloxane and polyaluminocarbosilane as taught in commonly owned U.S. Pat. No. 9,169,163 and included herein its entirety. Precursor chemicals for gallium arsenide may include combinations of the oligomeric organogallium compounds trimethyl gallium (TMGa), triethyl gallium (TEGa), arsine (AsH₃), and tertiary butylarsine (TBAs). Precursor chemicals for gallium nitride may include combinations of methyl hydrazine (Me₂N₂H₂) and gallium containing Group 13 oligomeric compounds such as trimethyl gallium (Me₃Ga). These precursors may be added to the ink to form gallium arsenide or gallium nitride with appropriate processing but, since they are not polymers, may not result in a crosslinked network that, upon pyrolysis, would form a ceramic structure without further additions to the ink. A method of forming a component of high temperature material using such an ink is disclosed in detail below.

FIG. 1 is a flow diagram of method 10 for forming a high temperature semiconductor or structural element containing silicon-based polymeric precursor materials in ink form. In the first step of the method, suitable ceramic polymer precursor materials are acquired in the form of liquid ink (step 12). The acquired ceramic polymer precursor materials may be polycarbosilane, polysilazane, polycarbosilazane, polysilane, polycarbosiloxane, boropolycarbosiloxane, polyaluminocarbosilane, metal-modified preceramic polymers or a mixture thereof, for a component to be made which includes a silicon-containing ceramic such as silicon carbide, silicon oxycarbide, silicon nitride, silicon carbonitride, silica and others known in the art. Filler materials may then be added to the ink (step 14). Active filler materials may be added that may react with various components in the ink and with other fillers that may be added to the ink when the ink is subsequently thermally processed. Passive filler materials, which have limited to no reaction with the ink, may also be added to the ink to adjust the rheology of the ink, to control the printing process and to contribute to the microstructure development and/or the formation of discrete, embedded phases or structures in the ink following thermal treatment. Optional liquid carriers may then be added to the ink (Step 16). The liquid carriers may be a solvent, a liquid monomer, a meltable solid or mixtures thereof.

In one example, the ceramic polymer precursor material may be a polycarbosilane, such as SMP-10 provided by StarFire Systems of Glenville, NY. Submicron or nano sized silicon metal powder (as an active filler) may be blended with the SMP-10 and a liquid (such as a solvent) to form an ink. Silicon carbide particulate material (as a passive filler) may be added to increase the viscosity of the resulting mixture so that the ink may be easily extruded through a nozzle to print high resolution features or to fill structural gaps. In other examples, submicron aluminum oxide powder may be employed as a passive filler material that may adjust the rheology of the ink mixture. As taught in commonly owned U.S. Pat. No. 6,627,126 and incorporated herein in entirety, excess carbon and selected amounts of refractory metals may be added to the ink to form refractory metal carbides in addition to silicon carbide to provide structural integrity of the precursor ink during subsequent thermal treatment. Suitable refractory metals include hafnium, tantalum, titanium, silicon, tungsten, zirconium, and mixtures thereof. In an embodiment, carbon, graphene or carbon nanotubes may be an additional active filler material. In an embodiment, a representative ink formulation would include approximately 10-60 vol % of polymeric precursor SMP-10, 5-20 vol % of silicon metal as active filler, 30-70 vol % of silicon carbide as passive filler, and hexane as a liquid carrier. A preferred vol % would be 35 vol % SMP-10, 10 vol % silicon metal and 55 vol % silicon carbide. Wider ranges may be about 1-100 vol % of polymer precursor, such as SMP-10, 0-70 vol % active filler such as silicon metal, 0-70 vol % passive filler such as silicon carbide, and 0-90 vol % liquid carrier such as hexane. Other nominally passive additions (which may have limited reaction depending on heat treatment) may include oxides such as silica, aluminum oxide, hafnium oxide, silicate glasses, and other dielectric type materials, as well as some metallic, intermetallic, or other electrically conductive materials including copper, gold, platinum, titanium, tungsten, silicides, conductive carbides, and others known in the art. Dopants, such as aluminum and boron, may provide semiconductor properties to the silicon carbide as they may dissolve in the material.

In the next step, the ink dispersion or solution with additives is shaped or formed into a usable structure by a DIW (step 18). The DIW process may be ink jet, extrusion, aerosol jet, plasma/thermal spray, electro spray, micro cold spray, 3D printing, fused deposition, micro pen writing, or other processes known in the art, which may be used to deliver the ink to a substrate.

Next, the filled polymer composite preceramic ink deposited on the substrate may be thermally processed, so that volatile organics may be driven out and the polymer matrix may undergo cross linking that causes the shape to become rigid and form a useful structure (step 20). Rigid shaping by cross linking may occur at temperatures up to about 400°C in typical embodiments. In addition to thermal processing, crosslinking may be initiated by radiation, UV, microwave, plasma and other treatments known in the art. In addition, crosslinking agents may be added to the ink formulation such as acrylate-based crosslinking agents for UV curing or free radical based initiators for thermal crosslinking. Extensive weight loss and volatile gas emission may be observed during thermal processing. If the filler materials are active, they may decompose at this stage and enter into the structure in different forms.

The component may then be pyrolyzed (step 22), which involves heating to temperatures up to about 1000°C in some embodiments (depending on the material used), to cause the polymer in the polymer precursor material to thermally decompose. Pyrolysis may be performed by oven heating, spark plasma sintering, radiation pyrolysis, microwave heating, laser pyrolysis, ion radiation, or other methods or combinations of methods. Further extensive shrinking and weight loss during pyrolysis are common, due to the loss of decomposition products from the starting materials in the form of gaseous species. The decomposing polymers transform into a generally amorphous (glassy) or nanocrystalline network of covalent bonds. In one example, a flowing gas such as argon may be used to continually remove decomposition products from the system. In the example mentioned above in which the component is made of polycarbosilane-derived silicon carbide, pyrolysis may burn off low molecular weight oligomeric components and organic constituents of the starting polycarbosilane, leaving excess carbon that may react with the silicon filler to form additional silicon carbide in the material.

Finally, further heating to temperatures over 1400°C (over 2000°C in some embodiments) results in a transformation of the generally amorphous or nanocrystalline structure into a more crystalline ceramic material (step 24), which contains the desired covalently bonded ceramic phase(s) such as silicon carbide. In the case of the example mentioned above, the ceramic may be crystalline silicon carbide. In some embodiments, the silicon carbide may primarily comprise α-SiC, β-SiC or a mixture of both.

### Discussion of Possible Embodiments

The following are non-exclusive descriptions of possible embodiments of the present invention.

A printable ink for forming electronic and structural components of ceramic material, may include: a polymeric or oligomeric ceramic precursor material and a filler material.

The printable ink of the preceding paragraph can optionally include, additionally and/or alternatively any, one or more of the following features, configurations and/or additional components:

The filler material may be an active and/or a passive filler material.

The ink blend may include a liquid carrier.

The ceramic material may be selected from a group consisting of silicon carbide, silicon oxycarbide, silicon nitride, silicon carbonitride, silicon oxycarbonitride, gallium arsenide, gallium nitride and mixtures thereof.

The ceramic material may be silicon carbide.

The polymeric or oligomeric precursor may be polycarbosilane, polycarbosilazane, polysilazane, polysilane, polycarbosiloxane, boropolycarbosiloxane, polyaluminocarbosilane, gallium containing Group 13 oligomeric compounds or mixtures thereof.

The polymeric precursor material may be SMP-10 polycarbosilane.

The liquid carrier may be at least one solvent, a liquid monomer, a meltable solid or mixtures thereof.

The active filler material may be carbon, graphene, carbon nanotubes (CNT), silicon, boron, hafnium, tantalum, titanium, tungsten, zirconium or mixtures thereof.

The passive filler material may be oxide glasses, carbides, nitrides, aluminides, phosphides, phosphonates, oxides, oxycarbides, oxynitrides or mixtures thereof.

A method of forming electronic and/or structural components of a ceramic material may include: preparing a printable ink solution for use in a direct ink writing (DIW) process comprised of a polymeric or oligomeric precursor material and a filler material; adjusting a rheology of the printable ink solution to be compatible with the DIW process; transferring the solution to a DIW system; forming a preceramic component with the DIW system; first heating the component to decompose the polymeric precursor and pyrolyze the component; and second heating the component to a temperature that transforms the component into a crystalline structure of the ceramic material.

The method of the preceding paragraph can optionally include, additionally and/or alternatively any, one or more of the following features, configurations and/or additional components;

The filler material may be an active and/or a passive filler material.

The ink solution may include a liquid carrier.

The ceramic material may be selected from a group consisting of silicon carbide, silicon oxycarbide, silicon nitride, silicon carbonitride, silicon oxycarbonitride, gallium arsenide, gallium nitride and mixtures thereof.

The ceramic material may be silicon nitride.

The polymeric or oligomeric precursor material may be polycarbosilane, polysilazane, polycarbosilazane, polysilane, polycarbosiloxane, boropolycarbosiloxane, polyaluminocarbosilane, gallium containing Group 13 oligomeric compounds or mixtures thereof.

The polymeric precursor material may be SMP-10 polycarbosilane.

The active filler material may be carbon, graphene, carbon nanotubes (CNT), silicon, boron, hafnium, tantalum, titanium, tungsten, zirconium or mixtures thereof.

The passive filler material may be oxide glasses, carbides, nitrides, aluminides, phosphides, phosphonates, oxides, oxycarbides, oxynitrides, or mixtures thereof.

The first heating may be at an intermediate temperature from about 400° C to about 1000 ° C.

The second heating may be at a final temperature from about 1000 ° C to about 2300° C.

The DIW process may be ink jet, extrusion, aerosol jet, plasma thermal spray, electrospray and combinations thereof.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A printable ink for forming electronic and structural components of ceramic material, the printable ink comprising a blend of:
a polymeric or oligomeric ceramic precursor material;
a filler material;
preferably wherein the filler material comprises an active and/or passive filler material, and/or wherein the ink blend comprises a liquid carrier.

2. The printable ink of claim 1, wherein the ceramic material is selected from a group consisting of silicon carbide, silicon oxycarbide, silicon nitride, silicon carbonitride, silicon oxycarbonitride, gallium arsenide, gallium nitride and mixtures thereof.

3. The printable ink of claim 1, wherein the polymeric or oligomeric precursor material comprises polycarbosilane, polysilazane, polycarbosilazane, polysilane, polycarbosiloxane, boropolycarbosiloxane, polyaluminocarbosilane, gallium containing Group 13 oligomeric compounds or mixtures thereof.

4. The printable ink of claim 3, wherein the polymeric precursor material comprises SMP-10 polycarbosilane.

5. The printable ink of any preceding claim, wherein the liquid carrier comprises at least one solvent, a liquid monomer, a meltable solid or mixtures thereof.

6. The printable ink of any preceding claim, wherein the active filler material comprises carbon, graphene, carbon nanotubes (CNT), silicon, boron, hafnium, tantalum, titanium, tungsten, zirconium or mixtures thereof.

7. The printable ink of any preceding claim, wherein the passive filler material comprises oxide glasses, carbides, nitrides, aluminides, phosphides, phosphonates, oxides, oxycarbides, oxynitrides or mixtures thereof.

8. A method of forming electronic and/or structural components of a ceramic material, the method comprising:
preparing a printable ink solution for use in a direct ink writing (DIW) process comprised of a polymeric or oligomeric ceramic precursor material, and a filler material,
preferably wherein the filler material comprises an active and/or passive filler material and/or wherein the ink solution comprises a liquid carrier;
adjusting a rheology of the printable ink solution to be compatible with the DIW process;
transferring the solution to a DIW system;
forming a preceramic component with the DIW system;
first heating the component to decompose the polymeric precursor and pyrolyze the component; and
second heating the component to a temperature that transforms the component into a crystalline structure of the ceramic material.

9. The method of claim 8, wherein the ceramic material is selected from a group consisting of silicon carbide, silicon oxycarbide, silicon nitride, silicon carbonitride, silicon oxycarbonitride, gallium arsenide, gallium nitride and mixtures thereof.

10. The method of claim 8, wherein the polymeric or oligomeric precursor material comprises polycarbosilane, polysilazane, polycarbosilazane, polysilane, polycarbosiloxane, boropolycarbosiloxane, polyaluminocarbosilane, gallium containing Group 13 oligomeric compounds or mixtures thereof.

11. The method of any of claims 8 to 10, wherein the active filler material comprises carbon, graphene, carbon nanotubes (CNT), silicon, boron, hafnium, tantalum, titanium, tungsten, zirconium or mixtures thereof.

12. The method of any of claims 8 to 10, wherein the passive filler material comprises oxide glasses, carbides, nitrides, aluminides, phosphides, phosphonates, oxides, oxycarbides, oxynitrides or mixtures thereof.

13. The method of any of claims 8 to 12, wherein first heating is at an intermediate temperature from about 400° C to about 1000° C.

14. The method of any of claims 8 to 13, wherein second heating is at a final temperature from about 1000° C to about 2300° C.

15. The method of any of claims 8 to 14, wherein the DIW process comprises ink jet, extrusion, aerosol jet, plasma thermal spray, electrospray or combinations thereof.
